# EUROPÄISCHE PATENTSCHRIFT

(11) **EP 0 854 548 B1**
(45) Veröffentlichungstag und Bekanntmachung des Hinweises auf die Patenterteilung: **06.08.2003**
(21) Anmeldenummer: 98100231.4
(22) Anmeldetag: 08.01.1998
(51) Int. Cl.: H01R 13/70, H01R 13/24, H01R 12/22

(54) **Elektrische Kontaktvorrichtung**
Electric contact device
Dispositif de contact électrique

(30) Priorität: 15.01.1997 DE 19701212
(43) Veröffentlichungstag der Anmeldung: 22.07.1998
(73) Patentinhaber: Patent-Treuhand-Gesellschaft für elektrische Glühlampen mbH, 81543 München (DE)
(72) Erfinder: Bernhard, Werner, 86316 Friedberg (DE)

(56) Entgegenhaltungen:
- DE-A- 3 741 566
- GB-A- 2 132 538
- US-A- 5 199 889
- US-A- 5 308 252
- US-A- 5 392 252
- US-A- 5 410 449

## Beschreibung

Die vorliegende Erfindung betrifft eine elektrische Kontaktvorrichtung, bestehend aus einem ersten und einem zweiten elektrischen Kontakt, wobei die Kontakte jeweils die elektrischen Anschlussstellen zweier elektrischer oder elektronischer Komponenten sind und der zweite Kontakt aus einem beweglichen Kontaktelement mit einer Auflagefläche besteht, wobei die Auflagefläche des zweiten Kontakts auf einer Kontaktfläche des ersten Kontakts zu liegen kommt und die Kontaktfläche insgesamt flach ausgebildet ist, wobei das bewegliche Kontaktelement ein Federelement ist und aus einem Federstahlband oder aus Kupfer oder einer gut leitfähigen Metall-Legierung besteht, wobei das Federelement aus einem einstückig mit einer Federlasche ausgebildeten Federkörper besteht und die Auflagefläche im Bereich des freien Endes der Federlasche ausgebildet ist, wobei die Federlasche zur Erzeugung einer Federwirkung mehrfach gebogen ist und die Länge der Federlasche derart gewählt ist, dass eine sichere Kontaktierung mit der Kontaktfläche des ersten Kontakts gewährleistet ist, wobei die Kontaktfläche aus Zinn und/oder Lötzinn besteht und auf einer elektrisch leitenden Leiterbahn aufliegt, die auf einer Kunststofffläche befestigt ist.

Vergleichbare Kontaktvorrichtungen sind aus der US-A-5199889 und der GB-A-2132538 bekannt. Des weiteren können bekannte Kontaktvorrichtungen zur leitenden Verbindung zweier elektrischer oder elektronischer Komponenten u.a. aus einem beweglichen Kontaktelement bestehen, welches auf einer leitenden Anschlussstelle eines Gegenkontaktes aufliegt. Insbesondere betrifft dies Kontaktvorrichtungen, die elektrische oder elektronische Komponenten einer Leiterplatte mit einer oder mehreren Anschlussstellen anderer Komponenten verbinden. Dabei liegt der Anschlusskontakt auf dem entsprechenden Anschluss der Leiterbahn auf.

Die herkömmlichen Kontaktvorrichtungen weisen jedoch verschiedenartige Nachteile auf. So wird üblicherweise der Anschlusskontakt der Leiterplatte mittels eines Lötauges ausgebildet Dies führt zu einem hohen Lötzinnauftrag auf den Leiterbahnen der Leiterplatte. Eine Abdeckung der Lötflächen während des Lötens kann dies nicht verhindern.

Weiterhin weist das Lötauge eine gekrümmte Oberfläche auf. Dies hat den Nachteil, dass bewegliche Kontaktelemente, die den leitenden Kontakt zu einer zweiten elektrischen oder elektronischen Komponente herstellen sollen, auf den steilen Flanken des Lötauges zu liegen kommen können, so dass die Gefahr eines Abrutschens und damit einer schlechten Kontaktierung gegeben ist. Eine sichere Kontaktierung ist hier nur mit einem weiteren Lötzinnauftrag und dem Verlöten der beiden elektrischen Kontakte möglich.

Es ist daher Aufgabe der vorliegenden Erfindung, eine elektrische Kontaktvorrichtung der eingangs genannten Art bereitzustellen, die eine sichere Kontaktierung zweier elektrischer oder elektronischer Komponenten unter Verringerung des Lötzinnauftrages gewährleistet.

Zur Lösung dieser Aufgabe dienen die Merkmale des unabhängigen Anspruches.

Vorteilhafte Ausgestaltungen sind in den Unteransprüchen beschrieben.

Bei einer erfindungsgemäßen elektrischen Kontaktvorrichtung, bestehend aus einem ersten und einem zweiten Kontakt, wird auf die Verwendung von großflächigen und gewölbten Lötaugen als erster elektrischer Kontakt verzichtet. Vielmehr kommt eine Auflagefläche des zweiten Kontaktes auf einer insgesamt flach ausgebildeten Kontaktfläche des ersten Kontaktes zu liegen. Die Kontaktfläche ist dabei in mehrere Einzelflächen unterteilt. Dadurch ist gewährleistet, dass es zu einer sicheren Kontaktierung zwischen der Kontaktfläche des ersten Kontaktes und der Auflagefläche des zweiten Kontaktes kommt. Zudem ergibt sich eine signifikante Einsparung der Menge an verwendetem Lötzinn. Durch die Aufteilung der Kontaktfläche des ersten Kontaktes in mehrere Einzelflächen ergibt sich eine weitere erhebliche Materialeinsparung. Weiterhin ist der als bewegliches Federelement ausgebildete zweite Kontakt derart gestaltet, dass mittels eines entsprechend langen Federwegs des Federelements und einem daraus resultierenden Nachfedern des Federelements ein Wegfließen des Zinns und/oder Lötzinns der Kontaktfläche verhindert wird. Auch dies gewährleistet eine erhebliche Einsparung an zu verwendenden Zinn und/oder Lötzinn.

Erfindungsgemäß wird die elektrische Kontaktvorrichtung in einer Niederdruckentladungslampe verwendet.

Weitere Einzelheiten, Merkmale, Ausgestaltungen und Vorteile ergeben sich aus der folgenden Beschreibung mehrerer zeichnerisch dargestellter Ausführungsbeispiele des Erfindungsgegenstandes:

Darin zeigen
- Figur 1: eine schematisch dargestellte Schnittzeichnung eines Teilbereiches einer Niederdruckentladungslampe mit der erfindungsgemäßen elektrischen Kontaktvorrichtung;
- Figuren 2a und 2b: eine schematisch dargestellte Aufsicht und eine Schnittzeichnung durch einen ersten Kontakt einer Kontaktvorrichtung gemäß dem Stand der Technik;
- Figuren 3a und 3b: eine schematisch dargestellte Aufsicht und eine Schnittzeichnung des ersten Kontaktes der erfindungsgemäßen Kontaktvorrichtung; und
- Figuren 4 und 5: jeweils eine schematisch dargestellte Aufsicht des ersten Kontaktes weiterer Ausführungsformen der erfindungsgemäßen Kontaktvorrichtung.

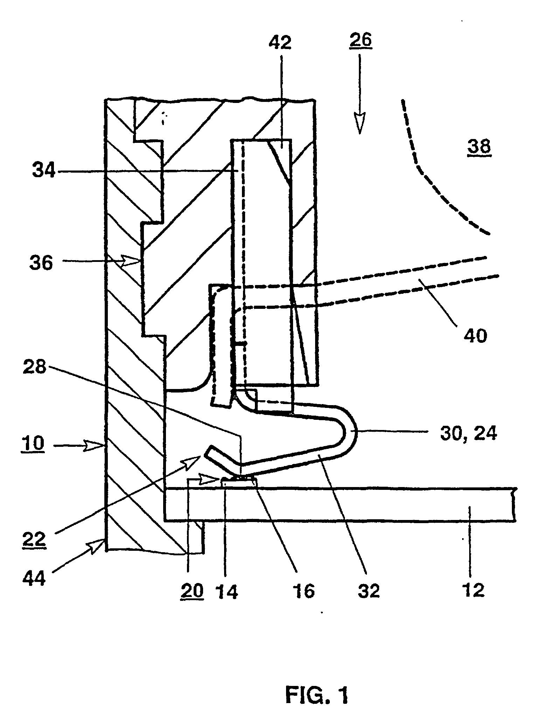

Figur 1 zeigt eine Schnittzeichnung durch eine elektrische Kontaktvorrichtung 10 innerhalb einer Niederdruckentladungslampe 26. Die Niederdrukkentladungslampe 26 besteht dabei aus einem Entladungskolben 38, der in ein Gehäuse 36 eingreift. In einem weiteren zweiten Gehäuse 44, welches lösbar mit dem ersten Gehäuse 36 verbunden ist, ist eine Kunststofffläche 12, nämlich eine Leiterplatte, integriert. Die beiden Gehäuse 36 und 44 bilden den Sockel der Niederdruckentladungslampe 26.

Ein erster elektrischer Kontakt 20 ist auf der Kunststofffläche 12 ausgebildet. Er weist eine flache Kontaktfläche 16 auf. In dem dargestellten Ausführungsbeispiel ist die Kontaktfläche 16 in mehrere Einzelflächen unterteilt. Die Kontaktfläche 16 liegt dabei auf einer elektrisch leitenden Leiterbahn 14 auf, die auf der Kunststofffläche 12 angeordnet ist. Üblicherweise besteht die Kontaktfläche 16 aus Zinn und/oder Lötzinn, die Leiterbahn 14 aus Kupfer oder einer Kupferlegierung oder einer anderen gut leitenden Metallegierung.

Der zweite Kontakt 22 besteht aus einem beweglichen Kontaktelement 24 mit einer Auflagefläche 28. Im dargestellten Ausführungsbeispiel ist das Kontaktelement 24 als Federelement 30 ausgebildet. Das Federelement 30 besteht dabei aus einem Federstahlband. Es kann allerdings auch aus Kupfer oder einer gut leitfähigen Metallegierung bestehen. Weiterhin erkennt man, daß das Federelement 30 eine Federlasche 32 und einen Federkörper 34 umfaßt, die einstückig miteinander verbunden sind. Die Auflagefläche 28 ist dabei im Bereich des freien Endes der Federlasche 32 angeordnet. Um eine gewünschte Federwirkung zu erzeugen, ist die Federlasche 32 mehrfach gebogen. Auch ist die Länge der Federlasche 32 derart gewählt, daß eine sichere Kontaktierung mit der Kontaktfläche 16 des ersten Kontaktes 20 gewährleistet ist.

Der als Federelement 30 ausgebildete zweite Kontakt 22 ist über eine Stromzuführung 40 mit dem Entladungsgefäß 38 der Niederdruckentladungslampe 26 verbunden. Diese erste elektrische Komponente ist über den zweiten Kontakt 22 und den ersten Kontakt 20 mit der zweiten elektronischen Komponente, nämlich der Leiterplatte 12, leitend verbunden.

In einem weiteren, nicht dargestellten Ausführungsbeispiel ist die Kontaktfläche 16 mit der Oberfläche der Kunststofffläche 12 bündig ausgebildet.

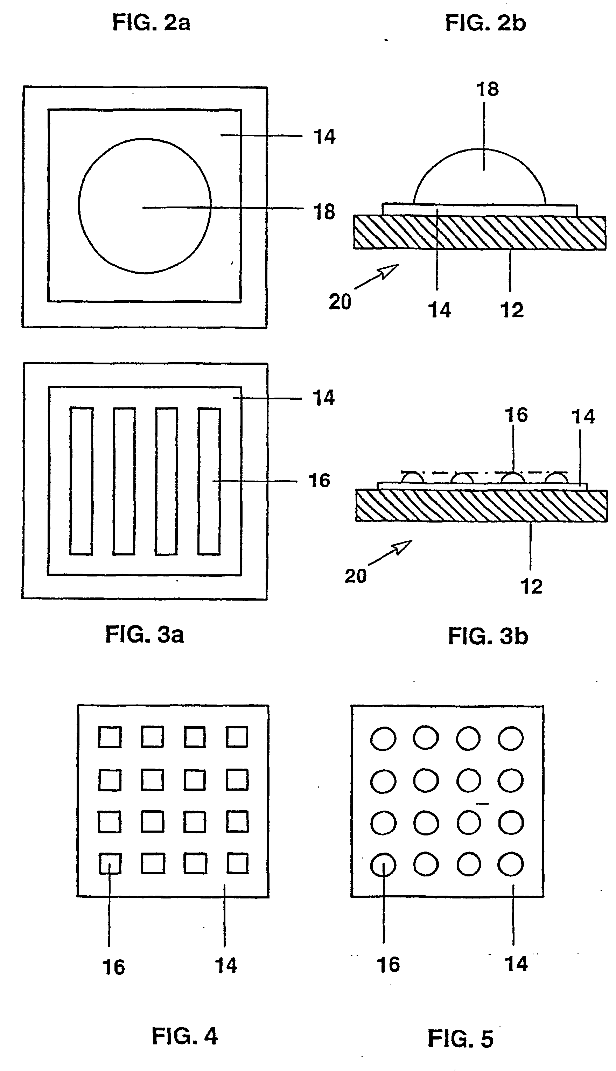

Die Figuren 2a und 2b zeigen einen dem ersten Kontakt 20 des Erfindungsgegenstandes entsprechenden ersten Kontakt einer Kontaktvorrichtung gemäß dem Stand der Technik. Man erkennt, daß ein großflächiger, hoher und gewölbter Lötzinnauftrag 18 auf der Leiterbahn 14 ausgebildet ist, wobei die Leiterbahn 14 auf der Kunststofffläche 12 angeordnet ist. Der hohe Materialverbrauch an Zinn bzw. Lötzinn wird hier deutlich. Zudem erkennt man die steilen Flanken des Lötauges 18, die eine sichere Kontaktierung dieses Kontaktelementes mit einem anderen verhindern können.

Die Figuren 3a und 3b zeigen dagegen in einer Aufsicht und in einer Schnittdarstellung den ersten Kontakt 20 gemäß der Erfindung. So zeigt Figur 3a eine streifenartig ausgebildete Kontaktfläche 16. Wie aus Figur 3b deutlich erkennbar, ist die Kontaktfläche 16 dabei insgesamt flach ausgebildet und in mehrere Einzelflächen unterteilt.

In Figur 4 sind die Einzelflächen der Kontaktfläche 16 rechteckig ausgebildet. Auch ist eine kreisförmige Ausbildung der Einzelflächen der Kontaktfläche 16 gemäß Figur 5 denkbar.

Die Unterteilung der Kontaktfläche 16 kann durch schmale Kupferstreifen oder durch ein entsprechendes Layout eines Lötstoplacks auf der Leiterbahn 14 realisiert werden.

Wie die Figuren 3a bis 5 zeigen, ergibt sich trotz der erheblichen Materialeinsparung auf Grund der insgesamt flach ausgebildeten und in mehrere Einzelflächen unterteilten Kontaktfläche 16 eine im Vergleich zum Stand der Technik größere Auflagefläche für den zweiten Kontakt 22. Zudem ist eine zuverlässigere Kontaktierung zwischen den beiden elektrischen Kontakten 20, 22 durch die mehrfach vorhandenen Berührungspunkte verwirklicht.

Wird das Federelement 22 auf die aus Zinn und/oder Lötzinn bestehende Kontaktfläche 16 kontaktiert, so drückt diese über die Auflagefläche 28 mit einer gewissen Kraft auf das Zinn/Lötzinn. Je nach Höhe und Dauer der Krafteinwirkung sowie der Höhe der Umgebungstemperatur kann dann das Zinn/Lötzinn teilweise unter der Auflagefläche 28 wegfließen. Dieses Wegfließen wird durch ein Nachfedern des Federelementes 22 mittels einem entsprechend langen Federweg ausgeglichen. Somit bleibt eine sichere Kontaktierung zwischen dem ersten und dem zweiten Kontakt 20, 22 gewährleistet.

Bei Kontaktierungen in klein dimensionierten elektrischen oder elektronischen Geräten ist es notwendig, Federelemente 22 mit sehr kleinen Abmessungen einzusetzen. In den in den Ausführungsbeispielen gemäß den Figuren 3a bis 5 erkennt man, daß aufgrund des geringen Zinn-/Lötzinnauftrags der für eine sichere und dauerhafte Kontaktierung des ersten und zweiten elektrischen Kontakts benötigte Federweg des Federelementes 22 klein gehalten werden kann. Je geringer der Zinn- bzw. Lötzinnauftrag ist, desto weniger Federweg wird benötigt, um ein mögliches Wegfließen des Zinns auszugleichen, so daß das Federelement 22 insgesamt kleiner ausgelegt werden kann.

## Patentansprüche

1. Elektrische Kontaktvorrichtung, bestehend aus einem ersten und zweiten elektrischen Kontakt (20, 22), wobei die Kontakte (20, 22) jeweils die elektrischen Anschluss-Stellen zweier elektrischer oder elektronischer Komponenten sind und wobei der zweite Kontakt (22) aus einem beweglichen Kontaktelement (24) mit einer Auflagefläche (28) besteht, die Auflagefläche (28) des zweiten Kontakts (22) auf einer Kontaktfläche (16) des ersten Kontakts (20) zu liegen kommt und die Kontaktfläche (16) insgesamt flach ausgebildet ist, wobei das bewegliche Kontaktelement (24) ein Federelement (30) ist und aus einem Federstahlband oder aus Kupfer oder einer gut leitfähigen Metall-Legierung besteht, wobei das Federelement (30) aus einem einstückig mit einer Federlasche (32) ausgebildeten Federkörper (34) besteht und die Auflagefläche (28) im Bereich des freien Endes der Federlasche (32) ausgebildet ist, wobei die Federlasche (32) zur Erzeugung einer Federwirkung mehrfach gebogen ist und die Länge der Federlasche (32) derart gewählt ist, dass eine sichere Kontaktierung mit der Kontaktfläche (16) des ersten Kontakts (20) gewährleistet ist, wobei die Kontaktfläche (16) aus Zinn und/oder Lötzinn besteht und auf einer elektrisch leitenden Leiterbahn (14) aufliegt, die auf einer Kunststofffläche (12) befestigt ist, **dadurch gekennzeichnet, dass** die Kontaktfläche (16) in mehrere Einzelflächen unterteilt ist, wobei das Federelement (30) derart ausgebildet ist, dass mittels eines entsprechend langen Federwegs des Federelements (30) und einem daraus resultierenden Nachfedern des Federelements (30) ein Wegfließen des Zinns und/oder Lötzinns der Kontaktfläche (16) verhindert wird.

2. Kontaktvorrichtung nach Anspruch 1, **dadurch gekennzeichnet, dass** die Kontaktfläche (16) streifenartig ausgebildet ist.

3. Kontaktvorrichtung nach Anspruch 1, **dadurch gekennzeichnet, dass** die Einzelflächen der Kontaktfläche (16) rechteckig und/oder kreisförmig und/oder polygonal ausgebildet sind.

4. Kontaktvorrichtung nach Anspruch 3, **dadurch gekennzeichnet, dass** die Einzelfächen un- und /oder symmetrische Muster ausbilden.

5. Kontaktvorrichtung nach einem der vorhergehenden Ansprüche, **dadurch gekennzeichnet, dass** die Kontaktfläche (16) mit der Oberfläche der Kunststofffläche (12) bündig ausgebildet ist.

6. Verwendung einer elektrischen Kontaktvorrichtung (10) gemäß Anspruch 1 in einer Niederdruckentladungslampe (26).

## Claims

1. Electrical contact device comprising a first and a second electrical contact (20, 22), the contacts (20, 22) in each case being the electrical contact points of two electric or electronic components, and the second contact (22) comprising a movable contact element (24) with a supporting surface (28), the supporting surface (28) of the second contact (22) coming to lie on a contact surface (16) of the first contact (20), and the contact surface (16) being of flat design overall, the movable contact element (24) being a spring element (30) and consisting of a spring steel strip, or of copper or an effectively conductive metal alloy, the spring element (30) consisting of a spring body (34) designed in one piece with a spring lug (32), and the supporting surface (28) being constructed in the region of the free end of the spring lug (32), the spring lug (32) being multiply bent to produce a spring action, and the length of the spring lug (32) being selected in such a way as to ensure reliable contact with the contact surface (16) of the first contact (20), the contact surface (16) consisting of tin and/or solder tin and resting on an electrically conducting conductor track (14) which is fastened on a plastic surface (12), **characterized in that** the contact surface (16) is subdivided into a plurality of individual surfaces, the spring element (30) being designed in such a way that the tin and/or solder tin of the contact surface (16) are/is prevented from flowing away by means of a spring excursion of appropriate length for the spring element (30) and of a springing, resulting therefrom, of the spring element (30).

2. Contact device according to Claim 1, **characterized in that** the contact surface (16) is of strip-type design.

3. Contact device according to Claim 1, **characterized in that** the individual surfaces of the contact surface (16) are of rectangular and/or circular and/or polygonal design.

4. Contact device according to Claim 3, **characterized in that** the individual surfaces form asymmetric and/or symmetrical patterns.

5. Contact device according to one of the preceding claims, **characterized in that** the contact surface (16) is designed flush with the plastic surface (12).

6. Use of an electrical contact device (10) in accordance with Claim 1 in a low-pressure discharge lamp (26).

## Revendications

1. Dispositif de contact électrique, constitué d'un premier et d'un second contact électrique (20, 22), dans lequel les contacts (20, 22) sont respectivement les points de raccordement électriques de deux composants électriques ou électroniques et dans lequel le second contact (22) comprend un élément de contact mobile (24) ayant une surface d'appui (28), la surface d'appui (28) du second contact (22) venant au contact d'une surface de contact (16) du premier contact (20), et la surface de contact (16) étant dans l'ensemble de forme plate, l'élément de contact mobile (24) étant un élément à ressort (30), en feuillard d'acier pour ressort ou en cuivre ou en un alliage métallique bon conducteur, l'élément à ressort (30) comprenant un corps de ressort (34) formé d'une seule pièce avec une patte de ressort (32), et la surface d'appui (28) étant formée dans la zone de l'extrémité libre de la patte de ressort (32), la patte de ressort (32) étant coudée plusieurs fois à des fins de production d'une action du ressort et la longueur de la patte de ressort (32) est sélectionnée de telle sorte qu'un contact fiable soit garanti avec la surface de contact (16) du premier contact (20), la surface de contact (16) étant en étain et/ou en étain de brasage et s'appliquant sur une piste conductrice (14) de l'électricité, qui est fixée sur une surface en matière plastique (12), **caractérisé en ce que** la surface de contact (16) est subdivisée en plusieurs surfaces individuelles, et l'élément à ressort (30) est constitué de telle sorte qu'un écoulement de l'étain et/ou de l'étain de brasage de la surface de contact (16) soit empêché au moyen d'un allongement des ressorts de l'élément à ressort (30) de longueur correspondante et d'un retour élastique en résultant de l'élément à ressort (30).

2. Dispositif de contact selon la revendication 1, **caractérisé en ce que** la surface de contact (16) est en forme de bande.

3. Dispositif de contact selon la revendication 1, **caractérisé en ce que** les surfaces individuelles de la surface de contact (16) ont une forme rectangulaire et/ou circulaire et/ou polygonale.

4. Dispositif de contact selon la revendication 3, **caractérisé en ce que** les surfaces individuelles forment des motifs dissymétriques et/ou symétriques.

5. Dispositif de contact selon l'une des revendications précédentes, **caractérisé en ce que** la surface de contact (16) est à affleurement avec la surface en matière plastique (12).

6. Utilisation d'un dispositif de contact électrique (10) conformément à la revendication 1 dans une lampe à décharge basse pression (26).
